# EUROPÄISCHE PATENTSCHRIFT

(11) **EP 1 678 721 B1**
(45) Veröffentlichungstag und Bekanntmachung des Hinweises auf die Patenterteilung: **06.05.2009**
(21) Anmeldenummer: 04802651.2
(22) Anmeldetag: 27.10.2004
(51) Int. Cl.: G11C 7/24, G11C 16/34

(54) **SPEICHERANORDNUNG UND VERFAHREN ZUM BETREIBEN EINER SOLCHEN**
MEMORY ASSEMBLY AND METHOD FOR OPERATING THE SAME
DISPOSITIF DE MEMOIRE ET PROCEDE PERMETTANT SON FONCTIONNEMENT

(30) Priorität: 28.10.2003 DE 10350168
(43) Veröffentlichungstag der Anmeldung: 12.07.2006
(73) Patentinhaber: Infineon Technologies AG, 81669 München (DE)
(72) Erfinder: KUND, Michael, 83104 Tuntenhausen (DE)
(74) Vertreter: Kottmann, Heinz Dieter
(86) Internationale Anmeldenummer: PCT/DE2004/002396
(87) Internationale Veröffentlichungsnummer: WO 2005/043544

(56) Entgegenhaltungen:
- US-A- 5 671 180
- US-A- 6 005 810
- US-B1- 6 633 500
- US-B1- 6 646 941

## Beschreibung

Die vorliegende Erfindung betrifft eine Speicheranordnung nach dem Oberbegriff des Patentanspruchs 1 sowie ein Verfahren zum Betreiben einer solchen Speicheranordnung nach dem Oberbegriff von Patentanspruch 8.

Gattungsgemäße Speicheranordnungen sind z. B. bekannt als Halbleiterspeicherbausteine vom SRAM-Typ oder von einem der verschiedenen, wieder beschreibbaren ROM-Typen wie EAROM, EPROM, EEPROM, Flash-Speicher etc.. All diesen Bausteintypen, die ja als wesentliche Bauteile halbleitende Materialien wie z. B. Silizium enthalten, ist gemeinsam, dass ein Auslesen der in ihnen gespeicherten Information zerstörungsfrei erfolgt, d. h., die in ihnen gespeicherte Information bleibt auch beim Auslesen in ihnen erhalten (im Gegensatz dazu erfolgt das Auslesen von gespeicherter Information aus DRAM-Speicheranordnungen zerstörend, was zur Folge hat, dass die ausgelesene Information unmittelbar nach ihrem Auslesen wieder in die betroffenen Speicherzellen zurückzuschreiben ist).

Eine spezielle gattungsgemäße Speicheranordnung sowie ein entsprechendes Verfahren sind aus der US 6,633,500 B1 bekannt.

Im Zuge der fortschreitenden Verkleinerung der Strukturen von integrierten Schaltungen, und somit auch im Zuge der fortschreitenden Verkleinerung der Strukturen von gattungsgemäßen Speicheranordnungen, wird neuerdings versucht, Speicheranordnungen zu schaffen, deren Speichermechanismus nicht mehr auf den von Halbleiterspeichern her bekannten Speichermechanismen beruht, sondern auf anderen. Beispiele für solche andere, bereits allgemein bekannte Speichermechanismen sind z. B. der ferroelektrische Typ (z. B. FeRAM) und der magnetische Typ (z. B. MRAM). Darüber hinaus wird aber auch an heute noch weitgehend unbekannten Speichertypen geforscht: beispielsweise stand im Internet am 13. Oktober 2003 Teil 2 des Artikels "Die Zukunft des Speichers" der Allgemeinheit zur Kenntnisnahme zur Verfügung, auffindbar anhand der Adresse "www.elektroniknet.de/topics/bauelemente/fachthemen/2002/020223".

Darin wurde auf Polymer-basierte FeRAMs und auf ein "Ovonics Unified Memory OUM" als künftige, neue Speichertechnologien hingewiesen. Weiterhin wurde in der Zeitschrift "Elettronica Oggi 316", Ausgabe Ottobre 2002, auf den Seiten 118 bis 123 ein neuer Speichermechanismus mit Zukunftschancen vorgestellt, nämlich ein elektrochemischer Speicher in PMC-Technologie (PMC = Programmable Metallization Cell). Bei wenigstens einem Teil dieser Speichermechanismen ist jedoch zu erwarten, dass bei entsprechend aufgebauten Speicheranordnungen Lesevorgänge zwar weitgehend zerstörungsfrei erfolgen können, dass sich jedoch ein durch das Auslesen verursachtes gewisses Ausmaß an (quantitativem) Verringern der in den betroffenen Speicherzellen enthaltenen Informationen nicht vermeiden lässt. Infolge davon wird bei mehrmaligem Auslesen aus ein- und derselben Speicherzelle die in dieser Speicherzelle gespeicherte Information, auch wenn sie digitalen Charakter hat, quantitativ abnehmen, was im Allgemeinen als Degradation bezeichnet wird. Damit lässt sich absehen, dass nach häufigem Auslesen die in einer solchen Speicherzelle enthaltene Informationsmenge insgesamt dann soweit abgesunken sein wird, dass diese Information bei weiteren Auslesevorgängen von einer Bewertungseinrichtung nicht mehr von einer Information mit dem entgegengesetzten logischen Inhalt unterscheidbar sein wird, so dass sich Lesefehler einstellen.

Eine technisch naheliegende und einfach realisierbare Lösung dieses Problems könnte darin liegen, dass jeder Lesevorgang so ausgestaltet wird, das sich an ihn unmittelbar darauf ein Wiedereinschreibvorgang anschließt mit dem Ergebnis, dass eine so aus einer Speicherzelle ausgelesene Information unmittelbar darauf wieder in dieselbe Speicherzelle zurückgeschrieben wird, so dass sie aufgrund der damit verbundenen Signalverstärkung dort, quantitativ betrachtet, wieder in vollem Umfang für weitere Lesevorgänge zur Verfügung steht. Solche Speicheranordnungen wären also entsprechend den allseits bekannten DRAM-Halbleiterspeichern zu gestalten und zu betreiben. Allerdings ist wohl auch einleuchtend, dass ein Wiedereinschreiben wie vorstehend beschrieben Zeit benötigt, welche wiederum den Betrieb entsprechender Speicheranordnungen in einem Umfang verlangsamen würde, der vom Anwender als inakzeptabel empfunden wird.

Aufgabe der vorliegenden Erfindung ist es deshalb, gattungsgemäße Speicheranordnungen so auszugestalten, dass ein durch mehrmaliges Auslesen der Information verursachtes quantitatives Absinken von in einer Speicherzelle gespeicherten Information wenigstens soweit unterbunden ist, dass durch weiteres Auslesen keine Lesefehler entstehen können. Aufgabe ist es weiterhin, ein entsprechendes Betriebsverfahren anzugeben.

Diese Aufgabe wird bei einer gattungsgemäßen Speicheranordnung gelöst durch die kennzeichnenden Merkmale des Patentanspruchs 1 sowie bei einem entsprechenden Betriebsverfahren mit den Merkmalen des Patentanspruchs 8. Vorteilhafte Aus- und Weiterbildungen sind in Unteransprüchen gekennzeichnet.

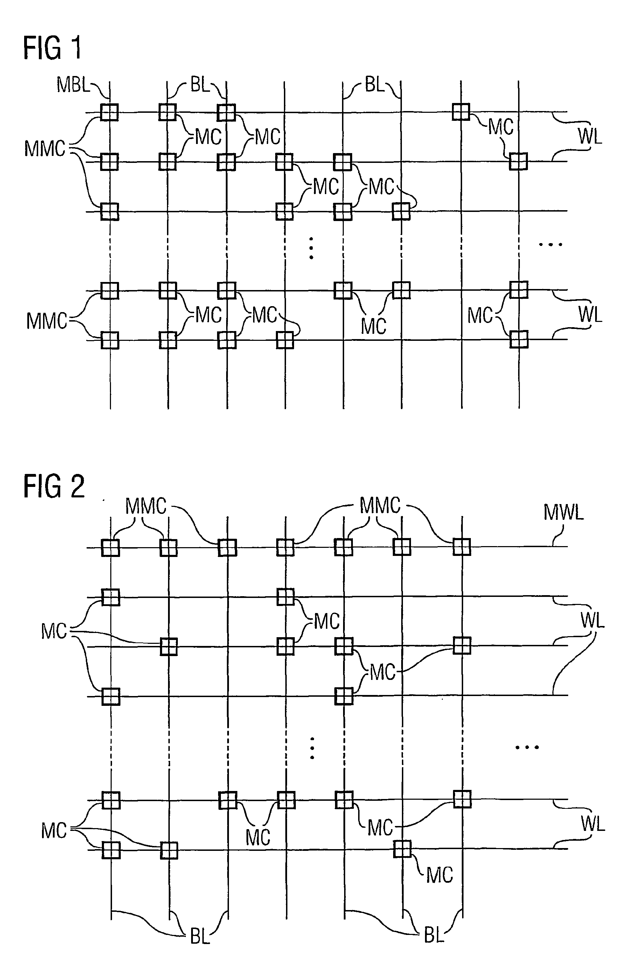

Die Erfindung wird nachstehend anhand einer Zeichnung näher erläutert. Dabei zeigen die Figuren 1 bis 3 verschiedene Ausführungsformen der vorliegenden Erfindung.

Figur 1 zeigt ausschnittsweise eine erste Ausführungsform der vorliegenden Erfindung. Sie ist angenommenermaßen in einem einzelnen Speicherbaustein realisiert. Diese Ausführungsform weist, wie allgemein üblich, wieder beschreibbare Speicherzellen MC auf, die entlang von Wortleitungen WL und von Bitleitungen BL angeordnet sind, nämlich an Kreuzungen der Wortleitungen WL mit den Bitleitungen BL. Die Speicherzellen MC sind von einem Typ, bei dem ein Auslesen der in ihnen gespeicherten Information weitgehend zerstörungsfrei erfolgt. Bei heute üblichen Speicheranordnungen können dies also beispielsweise Halbleiterspeicher von den vorgenannten ROM-Typen oder vom statischen RAM-Typ (SRAM) sein. Es können aber auch Speicheranordnungen mit Speichermaterialien und Speicherprinzipien sein, die erst in der Zukunft wirtschaftliche Bedeutung erlangen werden. Als Beispiel hierfür seien, stellvertretend für andere Möglichkeiten der Speicherung von Information, Speicheranordnungen genannt, deren Speicherprinzip darauf beruht, dass ein Festkörperelektrolyt bei Anlegen einer geeigneten Spannung Metall-Ionen zum Wandern innerhalb eines ansonsten isolierenden Elektrolyten veranlasst, so dass sich ein, je nachdem, ob dabei ein metallisch leitender Pfad ausgebildet wird oder nicht, unterschiedlicher Widerstandswert des Festkörperelektrolyten ergibt, welcher als Synonym für die Art der gespeicherten Information gilt ("log. 0" bzw. "log. 1").

Erfindungsgemäß ist nun bei dieser ersten Ausführungsform vorgesehen, dass entlang jeder Wortleitung WL noch eine zusätzliche Speicherzelle, nämlich eine sogenannte Merkerzelle MMC angeordnet ist. Diese ist vorzugsweise vom selben Speicherzellentyp wie die Speicherzellen MC. Insbesondere sollte sie ebenfalls von der Art sein, dass eine in ihr gespeicherte Information weitgehend zerstörungsfrei auslesbar ist. Vorteilhaft ist es dabei auch, wenn sie eine Speicherzelle vom nicht-flüchtigen Typ ist, so dass in ihr gespeicherte Information auch bei Abschalten der Versorgungsspannung erhalten bleibt. Die Merkerzellen MMC sind über die jeweiligen Wortleitungen WL und über eine Merkerbitleitung MBL adressierbar.

Bei erstmaliger Inbetriebnahme oder auch nach einem Rücksetzvorgang (wird noch beschrieben) weisen diese Merkerzellen MMC einen gegebenen Grundzustand auf, d. h., eine vorbestimmte Art von Information ist als Standardwert gespeichert (entweder "log. 0" oder "log. 1"). Wann immer nun beim anschließenden Betreiben der Speicheranordnung ein Lesezugriff auf eine Speicherzelle MC erfolgt, wird erfindungsgemäß in derjenigen Merkerzelle MMC, welche an derselben Wortleitung WL wie die zum Lesen adressierte Speicherzelle MC liegt, eine Information eingeschrieben, die komplementär ist zum vorgenannten Standardwert. Somit spiegelt der Inhalt einer jeden Merkerzelle MMC, d. h., die in ihr gespeicherte Information, stets wider, ob auf wenigstens eine der Speicherzellen MC, die entlang der der betrachteten Merkerzelle MMC zugehörigen Wortleitung WL angeordnet sind, wenigstens einmal lesend zugegriffen worden ist.

Bei dem erfindungsgemäßen Verfahren ist nun vorgesehen, dass Speicherzellen MC, die entlang einer solchen Wortleitung WL angeordnet sind, deren zugehörige Merkerzelle MMC einen Speicherinhalt aufweist (ist durch Auslesen der in der Merkerzelle MMC gespeicherten Information ermittelbar), der komplementär zum Standardwert ist, (gelegentlich) einem Refresh-Vorgang unterzogen werden. Bei einem Refresh-Vorgang, welcher als solcher ja vom Betrieb dynamischer Halbleiterspeicher (DRAM) her bekannt ist, wird bekanntlich in den zu refreshenden Speicherzellen gespeicherte Information ausgelesen und (meist noch im selben Lesezyklus) wieder in die betroffenen Speicherzellen zurückgeschrieben, wobei die diese Informationen repräsentierenden Signale üblicherweise auch noch mittels der den zu refreshenden Speicherzellen zugeordneten Leseverstärkern auf ihren ursprünglichen Wert verstärkt werden.

Dieser Effekt, dass bei einem Refresh-Vorgang eine (signalmäßig verstärkte) Information zurück geschrieben wird, wird hier in vorteilhafter Weise dazu ausgenutzt, dass eine in den Speicherzellen MC gespeicherte Information, die zwar einerseits als solche weitgehend zerstörungsfrei ausgelesen werden kann, die jedoch bei mehrfachem Auslesen trotzdem eine gewisse Degradation erfahren hat, wieder auf ihren (quantitativ betrachtet) ursprünglichen Wert zurückgebracht werden kann. Somit kann vermieden werden, dass die gespeicherte Information, die ja angenommenermaßen mit jedem Lesevorgang mengenmäßig etwas abnimmt, nach häufigem Auslesen irgendwann mengenmäßig so gering wird, dass sie vom zugehörigen Leseverstärker, der ja üblicherweise als Differenzverstärker ausgestaltet ist, nicht mehr als solche erkannt werden kann, so dass ein Lesefehler entsteht.

Der Umstand, dass ein solcher Refresh-Vorgang nur gelegentlich stattfindet, bietet den Vorteil, dass dafür wesentlich weniger Zeit und Energie aufzuwenden ist als wenn nach jedem Lesevorgang, wie eingangs bereits als theoretische Möglichkeit beschrieben, ein Zurückschreiben der ausgelesenen Information erfolgen würde. Der deutlich geringere Energieaufwand beruht darüber hinaus auch darauf, dass dem Refresh-Vorgang nur die Speicherzellen MC entlang solcher Wortleitungen WL unterzogen werden, entlang denen zuvor der Inhalt von Speicherzellen MC auch tatsächlich ausgelesen worden war, was im Unterschied steht zu den generell, das heißt, zwangsweise stattfindenden Refresh-Vorgängen bei den dynamischen Halbleiterspeichern (DRAM). Diese Vorteile treffen, analog, auch auf das weitere, später noch zu beschreibende Betriebsverfahren zu.

Bei diesem (wie auch bei dem nachfolgend noch zu beschreibenden) Betriebsverfahren ist es vorteilhaft, die in den den Refresh-Vorgang anstoßenden Merkerzellen MMC gespeicherte Information während des Refresh-Vorgangs oder anschließend daran auf den vorgenannten Standardwert zurückzusetzen. Weiterhin ist es günstig, das Durchführen eines Refresh-Vorgangs von einem weiteren eintretenden Ereignis oder Kriterium abhängig zu machen. Ein solches Kriterium kann z. B. ein der Speicheranordnung zugeführtes Signal sein, welches anzeigt, dass sich eine Steuerschaltung, gegebenenfalls auch ein Prozessor, an welche die erfindungsgemäße Speicheranordnung angeschlossen ist, gerade im Ruhezustand befindet. In einem solchen Fall verursacht der Refresh-Vorgang keinerlei Zeitverlust, da die Speicheranordnung in diesem Zeitraum ansonsten nicht aktiv betrieben würde. Andere Kriterien können auch sein (diese Aufzählung ist nur beispielhaft, nicht abschließend) das Einschalten eines Geräts, in dem die erfindungsgemäße Speicheranordnung enthalten ist, wobei durch das Einschalten ein spezielles, allgemein als "Power-On-Signal" bezeichnetes Signal entsteht, welches unmittelbar oder mittelbar der erfindungsgemäßen Speicheranordnung zugeführt wird, oder das Durchführen eines Ladevorgangs eines Geräts, welches die erfindungsgemäße Speicheranordnung enthält. Im letzteren Fall kann z. B. aus der Tatsache des Fließens eines Ladestroms ein Signal abgeleitet werden, welches dann den Refresh-Vorgang auslöst.

Figur 2 zeigt eine weitere vorteilhafte Ausführungsform der vorliegenden Erfindung: Dabei sind die von der ersten Ausführungsform her bereits prinzipiell bekannten Merkerzellen MMC entlang den Bitleitungen BL angeordnet. Die Merkerzellen MMC sind hier über die jeweilige Bitleitung BL und über eine der jeweiligen Merkerzelle MMC zugeordnete Merkerwortleitung MWL adressierbar. Funktion dieser Merkerzellen MMC und zugehöriges Betriebsverfahren entsprechen dem bereits vorhergehend Beschriebenen mit der Maßgabe, dass hier ein Refresh-Vorgang nur bezüglich solcher Speicherzellen MC durchgeführt wird, die entlang einer solchen Bitleitung BL angeordnet sind, bezüglich derer zuvor Speicherzellen MC ausgelesen worden waren. Auch das Einschreiben von Information in eine Merkerzelle MMC, ob ein Lesevorgang durchgeführt worden ist, erfolgt nur bezüglich solcher Speicherzellen MC, die entlang der einer jeweiligen Merkerzelle MC zugehörigen Bitleitung BL angeordnet sind.

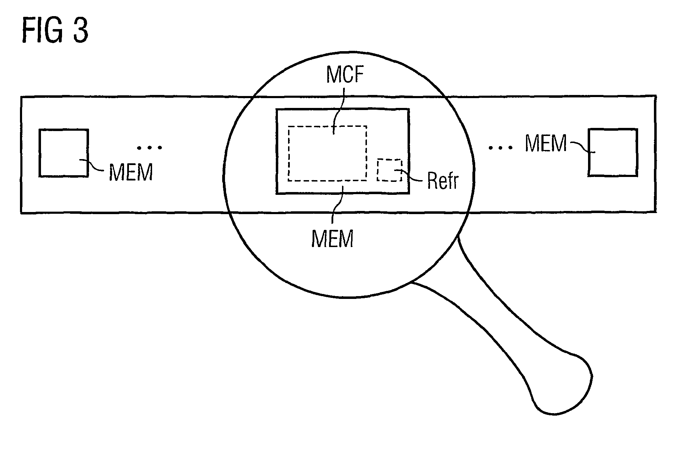

Figur 3 zeigt eine dritte Ausführungsform der vorliegenden Erfindung. Dabei ist die erfindungsgemäße Speicheranordnung durch eine Mehrzahl von Speicherbausteinen MEM realisiert, die einander funktionell zugeordnet sind. Dies ist z. B. bei den als solche allgemein bekannten Speichermodulen der Fall. In Figur 3 ist ein solches Speichermodul dargestellt. Speichermodule werden üblicherweise mittels Steuerschaltungen, häufig Controller genannt, angesteuert (hier nicht dargestellt). Diese Steuerschaltungen können z. B. die vorgenannten Signale, die, allgemein als "weiteres Ereignis" bezeichenbar, das Durchführen von Refresh-Vorgängen als solches auslösen, erzeugen und an die jeweils angeschlossenen Speicherbausteine MEM abgeben. Bei dieser Ausführungsform ist auch anhand eines einzelnen Speicherbausteins MEM, der symbolisch mittels einer Lupe vergrößert gezeigt ist, dargestellt, dass die einzelnen Speicherbausteine MEM über ihr Speicherzellenfeld MCF hinaus eine so genannte Refresheinrichtung Refr enthalten können, welche einen konkret gewünschten Refresh-Vorgang einleitet und durchführt. Auch die Speicheranordnungen nach den ersten beiden Ausführungsformen der vorliegenden Erfindung, in denen die Speicheranordnung gleich einem Speicherbaustein MEM ist, können eine solche Refresheinrichtung Refr aufweisen. Es ist allerdings auch vorstellbar, dass eine solche Refresheinrichtung Refr außerhalb der Speicheranordnung, z. B. innerhalb der vorgenannten Steuerschaltung, angeordnet ist.

### Bezugszeichenliste

- BL, WL: Bit-, Wortleitung
- MC: Speicherzelle
- MMC: Merkerzelle
- MBL, MWL: Merkerbit-, Merkerwortleitung
- MCF: Speicherzellenfeld
- MEM: Speicherbaustein
- Refr: Refresh-Einrichtung

## Patentansprüche

1. Speicheranordnung mit wieder beschreibbaren Speicherzellen (MC), die an Kreuzungen von Wortleitungen (WL) mit Bitleitungen (BL) angeordnet sind, bei der die Speicherzellen (MC) so ausgestaltet sind, dass ein Auslesen der in den Speicherzellen (MC) gespeicherten Informationen im Wesentlichen zerstörungsfrei erfolgt und die entweder je Wortleitung (WL) oder je Bitleitung (BL) eine Merkerzelle (MMC) aufweist, in der eine Information hinterlegbar ist,
**dadurch gekennzeichnet,**
**dass** die Merkerzelle (MMC) anzeigt, ob wenigstens eine der Speicherzellen (MC) entweder entlang der jeweiligen Wortleitung (WL) oder entlang der jeweiligen Bitleitung (BL) seit Auftreten eines Grundzustands einem Lesevorgang unterzogen worden ist.

2. Speicheranordnung nach Anspruch 1,
**dadurch gekennzeichnet,**
**dass** die Merkerzellen (MMC) vom selben Speicherzellentyp wie die Speicherzellen (MC) sind.

3. Speicheranordnung nach Anspruch 1 oder 2,
**dadurch gekennzeichnet,**
**dass** die Merkerzellen (MMC) von einem Speicherzellentyp sind, bei dem ein Auslesen der gespeicherten Information zerstörungsfrei erfolgen kann.

4. Speicheranordnung nach einem der vorhergehenden Ansprüche,
**dadurch gekennzeichnet,**
**dass** die Merkerzellen (MMC) vom nicht-flüchtigen Typ sind.

5. Speicheranordnung nach einem der vorhergehenden Ansprüche,
**dadurch gekennzeichnet,**
**dass** die Speicheranordnung ein einzelner Speicherbaustein (MEM) ist.

6. Speicheranordnung nach einem der vorhergehenden Ansprüche,
**dadurch gekennzeichnet,**
**dass** die Speicheranordnung eine Mehrzahl von einander zugeordneten Speicherbausteinen (MEM) ist.

7. Speicheranordnung nach einem der vorhergehenden Ansprüche,
**dadurch gekennzeichnet,**
**dass** die Speicheranordnung eine Refresheinrichtung (Refr) aufweist zum Durchführen eines Refreshvorgangs.

8. Verfahren zum Betreiben einer Speicheranordnung, welche wieder beschreibbare Speicherzellen (MC) aufweist, die an Kreuzungen von Wortleitungen (WL) mit Bitleitungen (BL) angeordnet sind, bei der die Speicherzellen (MC) so ausgestaltet sind, dass ein Auslesen der in den Speicherzellen (MC) gespeicherten Informationen im Wesentlichen zerstörungsfrei erfolgt, und welche entweder je Wortleitung (WL) oder je Bitleitung (BL) eine Merkerzelle (MMC) aufweist, in der eine Information hinterlegbar ist,
**dadurch gekennzeichnet,**
**dass** in eine jeweilige der Merkerzellen (MMC) eine Information eingeschrieben wird, die anzeigt, ob wenigstens eine der Speicherzellen (MC) entweder entlang der jeweiligen Wortleitung (WL) oder entlang der jeweiligen Bitleitung (BL) seit Auftreten eines Grundzustands einem Lesevorgang unterzogen worden ist, und
**dass** diejenigen Speicherzellen (MC) einem Refreshvorgang unterzogen werden, die entweder entlang einer solchen Wortleitung (WL) oder entlang einer solchen Bitleitung (BL) angeordnet sind, entlang deren zuvor wenigstens ein Lesevorgang stattgefunden hat.

9. Verfahren nach Anspruch 8,
**dadurch gekennzeichnet,**
**dass** das Auftreten eines Lesevorgangs als solches als Information in einer Merkerzelle (MMC) gespeichert wird, die entweder entlang einer vom Lesevorgang betroffenen Wortleitung (WL) oder entlang einer vom Lesevorgang betroffenen Bitleitung (BL) angeordnet ist.

10. Verfahren nach Anspruch 8 oder 9,
**dadurch gekennzeichnet,**
**dass** im Zuge des Durchführens des Refreshvorgangs die in den betroffenen Merkerzellen (MMC) gespeicherte Information auf einen Standardwert zurückgesetzt wird.

11. Verfahren nach einem der Ansprüche 8 bis 10,
**dadurch gekennzeichnet,**
**dass** das Durchführen des Refreshvorgangs durch ein weiteres, gegebenes Ereignis ausgelöst wird.

12. Speicheranordnung nach Anspruch 1, die weiterhin eine Refresheinrichtung (Refr) aufweist zum Durchführen eines Refreshvorgangs,
**dadurch gekennzeichnet,**
**dass** die Refresheinrichtung (Refr) so ausgelegt ist, dass sie je Merkerzelle (MMC) in Abhängigkeit von der in dieser Merkerzelle (MMC) hinterlegten Information einen Refreshvorgang für diejenigen Speicherzellen (MC) durchführt, die entlang der dieser Merkerzelle (MMC) zugehörigen Wortleitung (WL) oder Bitleitung (BL) angeordnet sind.

## Claims

1. Memory arrangement having rewritable memory cells (MC) which are arranged at crossovers between word lines (WL) and bit lines (BL), in which arrangement the memory cells (MC) are configured in such a manner that the information stored in the memory cells (MC) is essentially read out in a nondestructive manner, and which arrangement has a flag cell (MMC) either for each word line (WL) or for each bit line (BL), said flag cell being able to store an item of information,
**characterized in that**
the flag cell (MMC) indicates whether at least one of the memory cells (MC) either along the respective word line (WL) or along the respective bit line (BL) has been subjected to a reading operation since a basic state occurred.

2. Memory arrangement according to claim 1,
**characterized in that**
the flag cells (MMC) are of the same memory cell type as the memory cells (MC).

3. Memory arrangement according to claim 1 or 2,
**characterized in that**
the flag cells (MMC) are of a memory cell type in which the stored information can be read out in a nondestructive manner.

4. Memory arrangement according to one of the preceding claims,
**characterized in that**
the flag cells (MMC) are of the nonvolatile type.

5. Memory arrangement according to one of the preceding claims,
**characterized in that**
the memory arrangement is an individual memory chip (MEM).

6. Memory arrangement according to one of the preceding claims,
**characterized in that**
the memory arrangement is a plurality of memory chips (MEM) which are assigned to one another.

7. Memory arrangement according to one of the preceding claims,
**characterized in that**
the memory arrangement has a refresh device (Refr) for carrying out a refresh operation.

8. Method for operating a memory arrangement having rewritable memory cells (MC) which are arranged at crossovers between word lines (WL) and bit lines (BL), in which arrangement the memory cells (MC) are configured in such a manner that the information stored in the memory cells (MC) is essentially read out in a nondestructive manner, and which arrangement has a flag cell (MMC) either for each word line (WL) or for each bit line (BL), said flag cell being able to store an item of information,
**characterized in that**
an item of information is written to a respective one of the flag cells (MMC), which item of information indicates whether at least one of the memory cells (MC) either along the respective word line (WL) or along the respective bit line (BL) has been subjected to a reading operation since a basic state occurred, and
**in that** those memory cells (MC) which are arranged either along a word line (WL) or along a bit line (BL) along which at least one reading operation has previously taken place are subjected to a refresh operation.

9. Method according to claim 8,
**characterized in that**
the occurrence of a reading operation as such is stored as information in a flag cell (MMC) that is arranged either along a word line (WL) that is affected by the reading operation or along a bit line (BL) that is affected by the reading operation.

10. Method according to claim 8 or 9,
**characterized in that**
the information stored in the affected flag cells (MMC) is reset to a standard value when carrying out the refresh operation.

11. Method according to one of claims 8 to 10,
**characterized in that**
the carrying-out of the refresh operation is triggered by another given event.

12. Memory arrangement according to claim 1, which furthermore has a refresh device (Refr) for carrying out a refresh operation,
**characterized in that**
the refresh device (Refr) is designed in such a manner that, for each flag cell (MMC), it carries out a refresh operation, in a manner dependent on the information stored in said flag cell (MMC), for those memory cells (MC) which are arranged along the word line (WL) or bit line (BL) associated with said flag cell (MMC).

## Revendications

1. Dispositif de mémoire ayant des cellules (MC) de mémoire dans lesquelles on peut réécrire et qui sont disposées aux intersections de lignes (WL) de mot et de lignes (BL) de bit, dans lequel les cellules (MC) de mémoire sont telles qu'une lecture des informations mémorisées dans les cellules (MC) de mémoire s'effectue sensiblement sans destruction et soit la ligne (WL) de mot, soit la ligne (BL) de bit a une cellule (MMC) indicatrice dans laquelle une information peut être mise,
**caractérisé en ce que**
la cellule (MMC) indicatrice indique si au moins l'une des cellules (MC) de mémoire a été soumise, depuis l'apparition d'un état de base, à une opération de lecture, soit le long de la ligne (WL) respective de mot, soit le long de la ligne (BL) respective de bit.

2. Dispositif de mémoire suivant la revendication 1,
**caractérisé en ce que**
les cellules (MMC) indicatrices sont du même type que les cellules (MC) de mémoire.

3. Dispositif de mémoire suivant la revendication 1 ou 2,
**caractérisé en ce que**
les cellules (MMC) indicatrices sont d'un type de cellule de mémoire, dans lequel on peut effectuer sans destruction une lecture de l'information mémorisée.

4. Dispositif de mémoire suivant l'une des revendications précédentes,
**caractérisé en ce que**
les cellules (MMC) indicatrices sont du type non volatil.

5. Dispositif de mémoire suivant l'une des revendications précédentes,
**caractérisé en ce que**
le dispositif de mémoire est un module (MEM) de mémoire individuelle.

6. Dispositif de mémoire suivant l'une des revendications précédentes,
**caractérisé en ce que**
le dispositif de mémoire est une multiplicité de modules (MEM) de mémoire associés les uns aux autres.

7. Dispositif de mémoire suivant l'une des revendications précédentes,
**caractérisé en ce que**
le dispositif de mémoire a un dispositif (Refr) de rafraîchissement pour effectuer une opération de rafraîchissement.

8. Procédé pour faire fonctionner un dispositif de mémoire qui a des cellules (MC) de mémoire telles qu'une lecture des informations mémorisées dans les cellules (MC) de mémoire s'effectue sensiblement sans destruction, et qui a soit par ligne (WL) de mot, soit par ligne (BL) de bit une cellule (MMC) indicatrice dans laquelle une information peut être mise,
**caractérisé en ce que**
l'on peut écrire dans une respective des cellules (MMC) indicatrices une information qui indique si au moins l'une des cellules de mémoire a été soumise depuis l'apparition d'un état de base, à une opération de lecture, soit le long de la ligne (WL) respective de mot, soit le long de la ligne (BL) respective de bit, et
l'on soumet à une opération de rafraîchissement des cellules (MC) de mémoire qui sont disposées soit le long d'une ligne (WL) de mot, soit le long d'une ligne (BL) de bit telles que le long d'elle a eu lieu auparavant au moins une opération de lecture.

9. Procédé suivant la revendication 8,
**caractérisé en ce que**
l'on mémorise l'apparition d'une opération de lecture en tant que telle sous forme d'une information dans une cellule (MMC) indicatrice, qui est disposée soit le long d'une ligne (WL) de mot concernée par l'opération de lecture, soit le long d'une ligne (BL) de bit concerné par l'opération de lecture.

10. Procédé suivant la revendication 8 ou 9,
**caractérisé en ce que**
alors que l'on effectue l'opération de rafraîchissement, on ramène à une valeur standard l'information mémorisée dans les cellules (MMC) indicatrices concernées.

11. Procédé suivant l'une des revendications 8 à 10,
**caractérisé en ce que**
l'on déclenche l'opération de rafraîchissement par un événement donné supplémentaire.

12. Dispositif de mémoire suivant la revendication 1, qui a, en outre, un dispositif (Refr) de rafraîchissement,
**caractérisé en ce que**
le dispositif (Refr) de rafraîchissement est tel qu'il effectue, pour chaque cellule (MMC) indicatrice en fonction de l'information mise dans cette cellule (MMC) indicatrice, une opération de rafraîchissement des cellules (MC) de mémoire, qui sont disposées le long de la ligne (WL) de mot ou de la ligne (BL) de bit affectée à cette cellule (MMC) de mémoire.
